# EUROPEAN PATENT APPLICATION

(11) **EP 2 784 828 A1**
(43) Date of publication of application: **01.10.2014**
(21) Application number: 12851803.2
(22) Date of filing: 22.11.2012
(51) Int. Cl.: H01L 31/04

(54) **CZTS THIN-FILM SOLAR CELL, AND METHOD FOR PRODUCING SAME**

(30) Priority: 25.11.2011 JP 2011257893
(71) Applicant: Showa Shell Sekiyu K.K., Tokyo 135-8074 (JP)
(72) Inventor: SUGIMOTO, Hiroki, Tokyo 135-8074 (JP); KATOU, Takuya, Tokyo 135-8074 (JP); MURAOKA, Satoshi, Tokyo 135-8074 (JP)
(74) Representative: Bartels, Martin Erich Arthur
(86) International application number: PCT/JP2012/080347
(87) International publication number: WO 2013/077417

(57) **Abstract**

A CZTS-based thin film solar cell which has a high photovoltaic conversion efficiency which is provided with a substrate, a metal back electrode layer which is formed on the substrate, a p-type CZTS-based light absorption layer which is formed on the metal back electrode layer, and an n-type transparent conductive film which is formed on the p-type CZTS-based light absorption layer and which has a dispersed layer of ZnS-based fine particles at the interface between the p-type CZTS-based light absorption layer and the metal back electrode layer.

## Description

### Technical Field

The present invention relates to a CZTS-based thin film solar cell and a method of production of the same, more particularly relates to a CZTS-based thin film solar cell which has a high photovoltaic conversion efficiency and a method of production of the same.

### Background Art

In recent years, thin film solar cells which use chalcogenide-based compounds generally called CZTS as the p-type light absorption layer have come under the spotlight. This type of solar cell is made of a relatively inexpensive material and has a band gap energy which is suitable for solar light, so holds forth the promise of inexpensive production of highly efficient solar cells. CZTS is a Group I₂-(II-IV)-VI₄ compound semiconductor which contains Cu, Zn, Sn, S, or Se. As typical ones, there are Cu₂ZnSnS₄, Cu₂ZnSnSe₄, Cu₂ZnSn(S,Se)₄, etc.

A CZTS-based thin film solar cell comprises a glass substrate on which a metal back electrode layer is formed, on which a p-type CZTS-based light absorption layer is then formed, and further on which an n-type high resistance buffer layer and n-type transparent conductive film are successively stacked. As the material of the metal back electrode layer, molybdenum (Mo) or titanium (Ti), chromium (Cr), or another high corrosion resistant and high melting point metal is used. The p-type CZTS-based light absorption layer is, for example, formed by forming a Cu-Zn-Sn or Cu-Zn-Sn-S precursor film on a substrate formed with a molybdenum (Mo) back electrode layer by sputtering, vapor deposition, etc. and sulfurizing and/or selenizing this in an atmosphere which contains hydrogen sulfide or hydrogen selenide (for example, see PLT 1).

### Citations List

### Patent Literature

PLT 1. Japanese Patent Publication No. 2009-135316A

### Nonpatent Literature

NPLT 1. "Fabrication of p-type ZnO Thin Films via DC Reactive Magnetron Sputtering by Using Na as the Dopant Source", L. L. Yang et al., February 6, 2007, Journal of ELECTRONIC MATERIALS, Vol. 36, No. 4

### Summary of Invention

### Technical Problem

As explained above, a CZTS-based thin film solar cell is high in latent possibility, but at the present time, a product with a high photovoltaic conversion efficiency which can withstand practical use cannot be obtained. Much more progress in production technology is being sought. The present invention was made relating to this point. In particular, the object is the provision of a novel structure of a CZTS-based thin film solar cell and a method of production of the same which effectively suppress recombination of carriers at the back electrode side of the p-type CZTS-based light absorption layer to realize a high photovoltaic conversion efficiency.

### Solution to Problem

To solve the problem, in a first aspect of the present invention, there is provided a CZTS-based thin film solar cell which is provided with a substrate, a metal back electrode layer which is formed on the substrate, a p-type CZTS-based light absorption layer which is formed on the metal back electrode layer, and an n-type transparent conductive film which is formed on the p-type CZTS-based light absorption layer and which has a dispersed layer of ZnS-based fine particles at the interface between the p-type CZTS-based light absorption layer and the metal back electrode layer.

In the CZTS-based thin film solar cell, the dispersed layer of ZnS-based fine particles need not completely cover the surface of the metal back electrode layer. Further, the ZnS-based fine particles may have a size of 10 nm to 200 nmφ or so.

Further, the substrate may be alkali-containing glass which contains Na. Furthermore, an alkali barrier layer may be formed between the substrate and the metal back electrode layer.

Further, the ZnS-based fine particles may be any of ZnS, ZnSe, or ZnSSe. Furthermore, an n-type high resistance buffer layer may be provided between the p-type CZTS-based light absorption layer and the n-type transparent conductive film.

To solve the above problem, in a second aspect of the present invention, there is provided a method of production of a CZTS-based thin film solar cell which is comprised of forming a metal back electrode layer on a substrate, forming a metal precursor film which contains Cu, Sn, and Zn on the metal back electrode layer, sulfurizing and/or selenizing the metal precursor film to form a p-type CZTS-based light absorption layer, and forming an n-type transparent conductive film on the p-type CZTS-based light absorption layer, where the metal precursor film has a bottommost layer at the metal back electrode layer side, the bottommost layer being formed by Zn, a mixture of Zn and Cu, a mixture of Zn and a Group VI element, or a mixture of Zn, Cu and a Group VI element, and the sulfurization and/or selenization is performed at an ambient temperature of 540°C to 600°C for 5 minutes to 25 minutes.

In the method of production of a CZTS-based thin film solar cell, the substrate can also be formed by Na-containing alkali glass. In this case, it is also possible to form an alkali barrier layer between the substrate and the metal back electrode layer.

Further, the metal precursor film may be formed by first depositing a ZnS layer on the metal back electrode layer, then depositing Sn, Cu, or a mixture which contains these on the same. Furthermore, it is also possible to form an n-type high resistance buffer layer after forming the p-type CZTS-based light absorption layer and before forming the n-type transparent conductive film.

### Advantageous Effects of Invention

The CZTS-based thin film solar cell of the present invention is provided with a dispersed layer of ZnS-based fine particles at the interface of the p-type CZTS-based light absorption layer and metal back electrode layer. Among ZnS-based compounds, for example, ZnS has a bandgap of 3.7eV or so, ZnSe 2.7eV, and ZnSSe one between the same. These are all larger than the bandgaps of CZTS-based compounds. If such a dispersed layer of ZnS-based fine particles is present at the back surface of the p-type CZTS-based light absorption layer, a barrier to electrons is formed and the rate of back surface recombination of electrons falls. Due to this, the efficiency of collection of electrons is improved. On the other hand, so long as the dispersed layer is formed by ZnS-based fine particles, there are clearances between the fine particles. Holes can pass through these clearances to reach the metal back electrode layer, so the efficiency of collection of holes does not fall. As a result, the solar cell increases in photovoltaic conversion efficiency.

ZnS-based fine particles better exhibit the effect of an electron barrier the more the conductivity type is the p-type. It is known that a ZnS or other Zn (Group VI)-based semiconductor becomes the p-type if Na is added. For this reason, if using alkali glass which contains Na for the substrate, Na is supplied from the back surface side of the p-type CZTS-based light absorption layer and the ZnS-based fine particles are converted to p-types more. Due to this, a higher photovoltaic conversion efficiency can be realized.

The dispersed layer of ZnS-based fine particles is formed by forming the bottommost layer of the metal precursor film (metal back electrode layer side) by Zn, a mixture of Zn and Cu, a mixture of Zn and a Group VI element, or a mixture of Zn, Cu, and a Group VI element and sulfurizing and/or selenizing the metal precursor film at an ambient temperature of 540°C to 600°C for 5 minutes to 25 minutes. By 5 minute to 25 minute short sulfurization and/or selenization, the Zn or the mixture of Zn and Cu, the mixture of the Zn and a Group VI element, or the mixture of the Zn, Cu, and a Group VI element which is formed at the bottommost layer does not completely react to form a CZTS-based compound. Part remains as ZnS-based fine particles and forms the fine particles dispersed layer to thereby increase the photovoltaic conversion efficiency. Therefore, the present invention does not provide a passivation layer of an insulator different from the material of the solar cell such as in a crystalline solar cell. It can increase the photovoltaic conversion efficiency by just changing part of the steps in the conventional production process, so does not invite an increase in the production costs.

### Brief Description of Drawings

FIG. 1 is a cross-sectional view which shows the schematic structure of a CZTS-based thin film solar cell according to an embodiment of the present invention.
FIG. 2A is an energy band diagram for explaining the effects of a CZTS-based thin film solar cell according to the prior art.
FIG. 2B is an energy band diagram for explaining the effects of a CZTS-based thin film solar cell according to the present invention.
FIG. 3A is a graph which shows the distribution of concentration of component elements near the interface of the p-type CZTS-based light absorption layer and the metal back electrode layer of a sample with a sulfurization time of 45 minutes.
FIG. 3B is a graph which shows the distribution of concentration of component elements near the interface of the p-type CZTS-based light absorption layer and the metal back electrode layer of a sample with a sulfurization time of 15 minutes.
FIG. 3C is a graph which shows the distribution of concentration of component elements near the interface of the p-type CZTS-based light absorption layer and the metal back electrode layer of another sample with a sulfurization time of 15 minutes.
FIG. 3D is a view which shows the schematic structure of samples of FIG. 3A to FIG. 3C.
FIG. 4A is an electron micrograph of the cross-section near the interface between the p-type CZTS-based light absorption layer and the metal back electrode layer of a sample according to an embodiment of the present invention.
FIG. 4B is an electron micrograph of the sample of FIG. 4A with the top part peeled off by tape while leaving the vicinity near the interface with the Mo electrode.
FIG. 4C is a graph of the results of XRD analysis near the interface of the p-type CZTS-based light absorption layer and metal back electrode layer of the sample which is shown in FIG. 4A.
FIG. 5 is a schematic view for explaining a method of production of a CZTS-based thin film solar cell according to an embodiment of the present invention.

### Description of Embodiments

In general, the contact interface between the light absorption layer (semiconductor layer) and metal back electrode layer in a solar cell is a part which has a high density of dangling bonds and other crystal defects and where the speed of recombination of carriers becomes the fastest. Therefore, in a crystalline solar cell which is made using a conventional silicon wafer as a material, a point contact structure which uses a high quality passivation film is employed between the light absorption layer and the back electrode layer and reduction of the speed of recombination of carriers is sought.

However, in current CZTS-based thin film solar cells, realization of the point contact which is employed in crystalline solar cells is difficult. When applying the above art relating to crystalline silicon solar cells to a CZTS-based thin film solar cell, it is necessary to form a reduced defect, high quality insulating film (passivation film) between the semiconductor layer and electrode layer, but art for forming such an insulating film by a thin film has not yet been established. While there is a possibility of realization by future technical innovation, in that case as well, the production process would be complicated and an increase in manufacturing costs would be invited.

Therefore, in the present invention, a novel structure of a CZTS-based thin film solar cell and a method of production of the same which can realize an effect of inhibiting carrier recombination equal to or better than that of conventional point contact without using an insulating film are proposed.

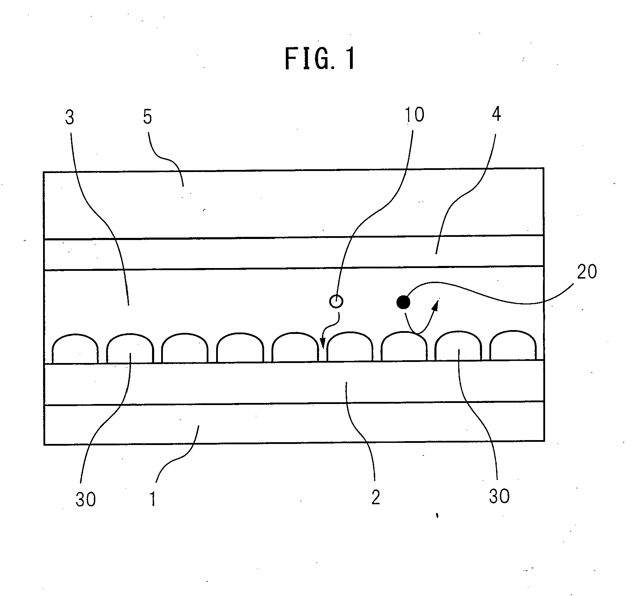

FIG. 1 is a cross-sectional view which shows the schematic structure of a CZTS-based thin film solar cell according to an embodiment of the present invention. Note that, in the figures shown below as a whole, the same reference numerals indicate the same or similar components, so overlapping explanations are not given. Furthermore, the figures are meant only to explain the present invention. Therefore, the sizes of the layers in the figures do not correspond to the actual scales.

In FIG. 1, 1 indicates a glass substrate, 2 a back electrode layer made using Mo or another metal as a material, 3 a p-type CZTS-based light absorption layer, 4 an n-type high resistance buffer layer, and 5 an n-type transparent conductive film. Here, the p-type CZTS-based light absorption layer 3 has a dispersed layer 30 which is made of ZnS-based fine particles as a material at the interface with the metal back electrode layer 2. Note that, when using an alkali-containing glass which contains Na for the substrate 1 etc., sometimes an alkali barrier layer (not shown) which is formed by silica is formed between the substrate 1 and metal back electrode layer 2.

"ZnS based" indicates a compound of Zn (zinc) and a Group VI element, for example, ZnS, ZnSe, and ZnSSe. When forming a p-type CZTS-based light absorption layer 3 by only sulfurization, the ZnS-based fine particles become ZnS fine particles. When forming the p-type CZTS-based light absorption layer 3 by just selenization, the compound becomes ZnSe, while when performing both selenization and sulfurization, it becomes ZnSSe. Further, in the dispersed layer of ZnS-based fine particles, the ZnS-based compound does not cover the entire surface of the metal back electrode layer 2 as a layer. It is present as a group of fine particles. The clearances between the fine particles or in the group form paths of passage of holes. In this case, part of the metal back electrode layer 2 is not covered by the ZnS-based fine particle dispersed layer 30. Part of the layer may be exposed in state. The dispersed layer 30 of ZnS-based fine particles is, for example, formed to a thickness of up to 300 nm or so. The particles have sizes of 10 nm to 200 nmφ or so.

Usually, the p-type CZTS-based light absorption layer 3 is formed by forming the metal precursor film which contains Cu, Zn, and Sn on the metal back electrode layer 2, then sulfurizing and/or selenizing this a 500°C to 650°C atmosphere which contains hydrogen sulfide and/or hydrogen selenide. When sulfurizing a metal precursor film which contains Cu, Zn, and Sn in a hydrogen-sulfide containing atmosphere, a p-type CZTS-based light absorption layer 3 which is comprised of Cu₂ZnSnS₄ is formed. On the other hand, if selenizing the metal precursor film in a hydrogen selenide-containing atmosphere, a p-type CZTS-based light absorption layer 3 which is comprised of Cu₂ZnSnSe₄ is formed. Alternatively, by selenizing and sulfurizing the same metal precursor film, a p-type CZTS-based light absorption layer 3 which is comprised of Cu₂ZnSn(S,Se)₄ is formed.

The n-type high resistance buffer layer 4, for example, is a thin film of a compound which contains Cd, Zn, and In (film thickness 3 nm to 50 nm or so). Typically, it is formed by CdS, ZnO, ZnS, Zn(OH)₂, In₂O₃, In₂S₃, or a mixed crystal of the same comprised of Zn(O,S,OH) or In(O,S,OH). This layer is generally formed by the chemical bath deposition (CBD), but as a dry process, metalorganic chemical vapor deposition (MOCVD) or atomic layer deposition (ALD) may also be applied. Note that, the "CBD" dips a base material in a solution which contains a chemical species forming a precursor and causes an uneven reaction to proceed between the solution and the surface of the base material to deposit a thin film on the base material. The n-type high resistance buffer layer 4 is not a layer which is necessarily required as a solar cell. An n-type transparent conductive film 5 may also be directly formed on the p-type CZTS-based light absorption layer 3.

The n-type transparent conductive film 5 is formed by a material which has an n-type of conductivity, has a broad bandgap, is transparent, and is low in resistance to a film thickness of 0.05 to 2.5 µm or so. Typically, there is a zinc oxide-based thin film (ZnO) or ITO thin film. In the case of a ZnO film, Group III elements (for example, Al, Ga, and B) can be added as a dopant to obtain a low resistance film. The n-type transparent conductive film 5 can be formed by sputtering (DC, RF) etc. other than MOCVD.

The inventors thought that by forming a dispersed layer 30 of ZnS-based fine particles at the interface of the p-type CZTS-based light absorption layer 3 and the metal back electrode layer 2 as shown in FIG. 1, it would be possible to increase a CZTS-based thin film solar cell in photovoltaic conversion efficiency. The reason is that ZnS has a larger bandgap than a CZTS compound. That is, ZnS is a semiconductor which has a bandgap of 3.7eV, ZnSe 2.7eV, and ZnSSe a large one between them. These are all larger than the bandgap of the p-type CZTS-based light absorption layer 3. Therefore, by such a semiconductor being present at the interface of the metal back electrode layer 2 and the p-type CZTS-based light absorption layer 3, a barrier to the electrons 20 is formed and back surface recombination of the electrons is suppressed. As a result, it is believed that the efficiency of collection of electrons is improved and the solar cell is increased in photovoltaic conversion efficiency.

Note that, it is important that the ZnS-based fine particles which are present at the interface between the metal back electrode layer 2 and p-type CZTS-based light absorption layer 3 be dispersed rather than layered. The clearance between the fine particles has to form paths for passage for holes 10 to reach the metal back electrode layer 2. Further, the more the ZnS-based fine particles are p-type in conductivity type, the more the effect as a barrier of electrons is exhibited. It is known that ZnS or another Zn(Group VI)-based semiconductor becomes the p-type if Na is added (see NPLT 1). Therefore, if using glass which contains Na as the substrate 1, Na is supplied by diffusion from the metal back electrode layer 2 side to the p-type CZTS-based light absorption layer 3 and therefore the ZnS-based fine particles contain a large amount of Na. Due to this, the ZnS-based fine particles are further converted to the p-type (higher concentration) and the effect as an electron barrier is increased.

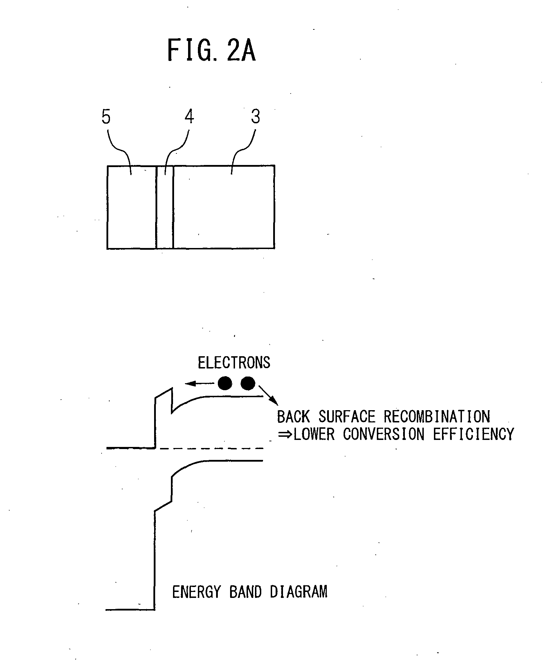

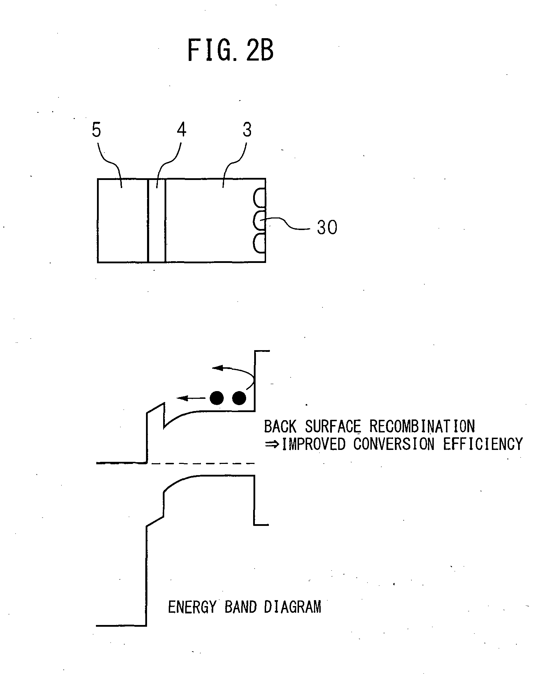

FIGS. 2A and 2B are views for explaining the effect of inhibition of recombination of carriers by the dispersed layer of ZnS-based fine particles. FIG. 2A shows as reference an energy band diagram at the time of generation of power by a conventional CZTS-based thin film solar cell, while FIG. 2B shows an energy band diagram at the time of generation of power by a CZTS-based thin film solar cell according to the present invention. As shown in FIG. 2A, in a p-type CZTS-based light absorption layer 3 which does not have a dispersed layer 30 of ZnS-based fine particles, the electrons which move in the direction of the metal back electrode layer easily recombine with the holes which collect at that part and the solar cell is made to fall in photovoltaic conversion efficiency. As opposed to this, in the CZTS-based thin film solar cell which is shown in FIG. 2B, due to the dispersed layer 30 of ZnS-based fine particles, an electron barrier is formed between the metal back electrode layer 2 and p-type CZTS-based light absorption layer 3. Due to this barrier, the electrons 20 bounce back in the direction of the light receiving surface of the p-type CZTS-based light absorption layer 3. As a result, recombination of the electrons and holes is inhibited at the back electrode side and the photovoltaic conversion efficiency of the solar cell is improved.

Below, the method of effectively forming the dispersed layer 30 of ZnS-based fine particles will be explained. The inventors ran experiments on forming the above p-type CZTS-based light absorption layer 3 by changing the production conditions in various ways and as a result discovered that by adjusting the order of stacking of the metal precursor film and the temperature and time of sulfurization/selenization, it is possible to form this layer 30 and obtain a CZTS-based thin film solar cell with superior photovoltaic conversion efficiency without providing any special step for forming a dispersed layer 30 of ZnS-based fine particles. In particular, by forming as the bottommost layer of the metal precursor film (layer which contacts metal back electrode layer 2) Zn or a mixture of Zn and Cu, a mixture of Zn and a Group VI element, or a mixture of Zn, Cu, and a Group VI element (below, mixture which contains Zn) and further by shortening the sulfurization/selenization time of the metal precursor film, the photovoltaic conversion efficiency is greatly improved.

In the past, the sulfurization/selenization when producing a CZTS-based thin film solar cell was considered to require a considerably long time of 2 or 3 hours (for example, see PLT 1, paragraph 0031). In this regard, in the experiments of the inventors etc., sulfurization of a considerably shorter time than the conventional method of production, for example, 15 minutes or so, enabled improvement of the photovoltaic conversion efficiency in the CZTS-based thin film solar cell. Therefore, to confirm this effect, Experiments 1 to 3 which are shown in the following Table 1 were performed while changing the sulfurization conditions of the metal precursor film. In these experiments, the bottommost layer of the metal precursor film (on interface with metal back electrode layer) was formed by ZnS.

**Table 1**

| Precursor | Precursor stacking order | Sulfurization temperature | Sulfurization time | Photovoltaic conversion efficiency |
|---|---|---|---|---|
| Experiment 1 | Cu/Sn/ZnS/Mo | 560°C | 45 min | 3.21% (Voc: 586 mV, Jsc: 9.63 mA/cm², FF: 0.570) |
| Experiment 2 | Sn/Cu/ZnS/Mo | 560°C | 15 min | 4.12% (Voc: 602 mV, Jsc: 15.51 mA/cm², FF: 0.441) |
| Experiment 3 | Cu/Sn/ZnS/Mo | 560°C | 15 min | 5.43% (Voc: 581 mV, Jsc: 17.78 mA/cm², FF: 0.526) |

Note that, the VOC of the solar cell indicates the open voltage, Jsc indicates the short-circuit current density, and FF indicates the fill factor.

In Experiments 1 to 3, as the substrate 1, Na-containing alkali glass is used, but in Experiments 1 and 2, a thick alkali barrier layer is formed between the substrate 1 and the metal back electrode layer 2 to suppress the diffusion of Na from the substrate 1. On the other hand, in Experiment 3, a thin alkali barrier layer is formed between the substrate 1 and the metal back electrode layer 2. As a result, the p-type CZTS-based light absorption layer 3 of the sample which was formed in Experiment 3 contains a considerable amount of Na supplied from the substrate 1 through the metal back electrode layer 2.

As clear from Table 1, compared with the Experiment 1 sample with a sulfurization time of 45 minutes, in the Experiment 2 sample and the Experiment 3 sample with a sulfurization time of 15 minutes, large improvements are seen in the photovoltaic conversion efficiency. Furthermore, even with the same sulfurization time of 15 minutes, in the Experiment 3 sample with a high Na concentration, the photovoltaic conversion efficiency is further improved. In particular, in the Experiment 2 sample and the Experiment 3 sample, the short-circuit current density Jsc greatly increases compared with the Experiment 1 sample. The increase of the short-circuit current density Jsc greatly contributes to improvement of the photovoltaic conversion efficiency.

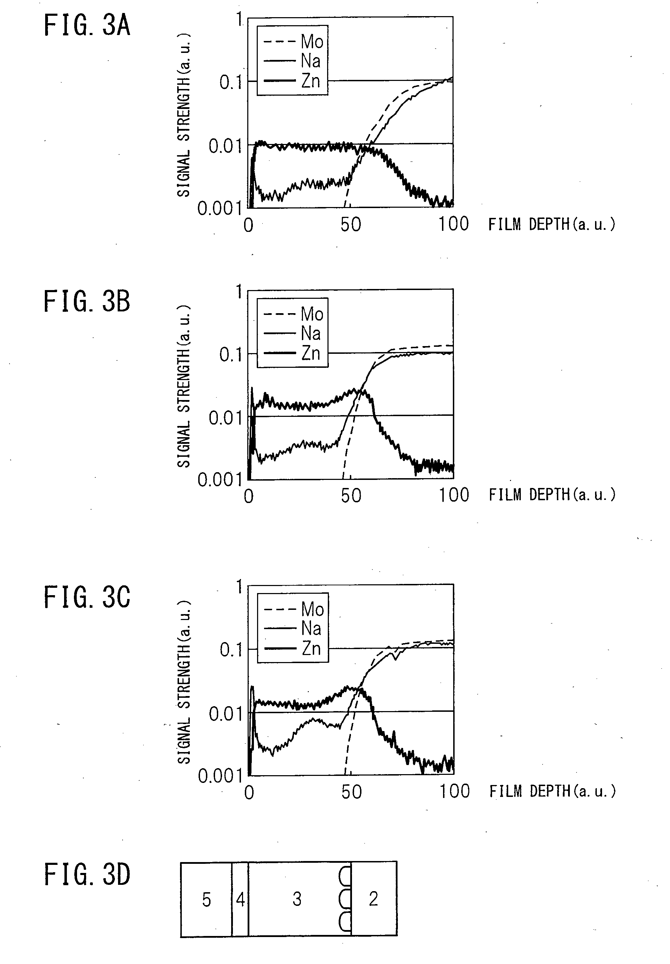

FIGS. 3A to 3C show the distribution of concentration of component elements near the interface of the p-type CZTS-based light absorption layer 3 and Mo metal back electrode layer 2 for the samples of the Experiment 1 to Experiment 3. In FIGS. 3A to 3C, the ordinate indicates the signal strength of the output at the time of analysis of the concentration, while the abscissa indicates the depth in the film thickness direction, both in arbitrary units (a.u.) The dotted line of the figure is the curve of the distribution of concentration of Mo. The rising portion of the curve is the vicinity of the interface between the p-type CZTS-based light absorption layer 3 and the Mo metal back electrode layer 2. The bold line in the figure is the curve of the distribution of concentration of Zn, while the fine line is the curve of the distribution of concentration of Na. Note that in FIGS. 3A to 3C, the film thickness is related to the solar cell structure, so FIG. 3D shows the general structure of the CZTS-based thin film solar cell.

FIG. 3A shows the results of analysis of the Experiment 1 sample. From this figure, it will be understood that in the Experiment 1 sample, the concentration of Zn is substantially constant along the film thickness direction of the p-type CZTS-based light absorption layer 3. This is believed because the sulfurization time is a relatively long 45 minutes, so Zn diffuses in the layer thickness direction and is uniformly distributed. In FIGS. 3B and 3C which show the results of analysis of the Experiment 2 sample and Experiment 3 sample, the concentration of Zn becomes higher near the interface of the p-type CZTS-based light absorption layer 3 and the metal back electrode layer 2. This is believed to be because the sulfurization time is a short 15 minutes, so not all of the ZnS which was deposited near the interface reacts to form CZTS, but part remains near the interface in the unreacted state.

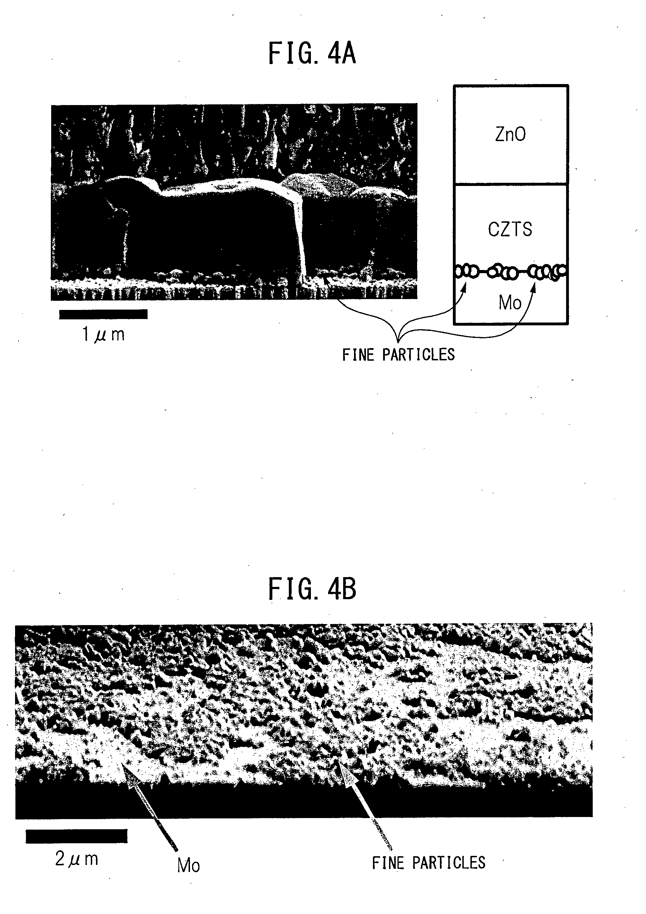

FIGS. 4A to 4C show an electron micrograph and the result of elementary analysis by XRD of solar cell samples which have high Zn concentration parts at the interface between the p-type CZTS-based light absorption layer 3 and the metal back electrode layer 2 (for example, Experiment 2 or Experiment 3 samples of Table 1). FIG. 4A is an electron micrograph at the cross-section in the film thickness direction of a CZTS-based thin film solar cell, while FIG. 4B is an electron micrograph of a sample with a top part peeled off by tape while leaving the vicinity of the interface with the Mo electrode when seen from above at a slant. FIG. 4A illustrates the general structure of the cross-section of a CZTS-based thin film solar cell for reference for identifying the parts in the photo.

As clear from FIG. 4A, a dispersed layer of fine particles is formed at the interface between the p-type CZTS-based light absorption layer 3 and the Mo metal back electrode layer 2. It will be understood that this dispersed layer, as shown in FIG. 4B, does not completely cover the Mo metal back electrode layer 2 and that Mo is partially exposed. Further, from FIGS. 4A and 4B, the size of the ZnS fine particles is 10 nm to 200 nmφ or so, while the thickness of the fine particle dispersed layer is up to 300 nm or so.

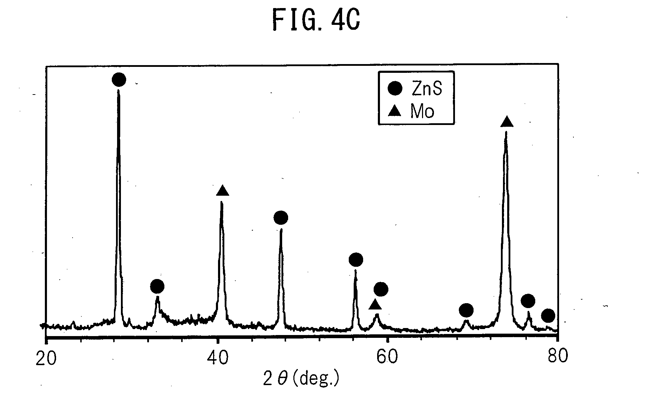

The surface of FIG. 4B was analyzed by elementary analysis by XRD, whereupon, as shown in FIG. 4C, remarkable peaks of ZnS and Mo were observed. From this, it is confirmed that the fine particles which are formed at the interface of the p-type CZTS-based light absorption layer 3 and the metal back electrode layer 2 are ZnS.

As a result, in the samples of Experiments 2 and 3 in which large improvements in photovoltaic conversion efficiency were seen, high temperature, short sulfurization treatment enabled the formation of a dispersed layer 30 of ZnS-based fine particles at the interface between the p-type CZTS-based light absorption layer 3 and the metal back electrode layer 2. On the other hand, in the Experiment 1 sample which has a low photovoltaic conversion efficiency, since the high temperature sulfurization treatment extended over a long period of time, it is learned that the Zn at the interface completely reacts to be uniformly contained in the layer of the p-type CZTS-based light absorption layer 3 as a whole and a dispersed layer 30 of ZnS-based fine particles is not formed. In this way, improvement of the photovoltaic conversion efficiency is governed by whether there is a dispersed layer 30 of ZnS-based fine particles present at the interface between the p-type CZTS-based light absorption layer 3 and the metal back electrode layer 2. Note that, in Experiment 3, the concentration of Na at the interface is higher than in the sample of Experiment 2. It is guessed that the ZnS fine particles of the Experiment 3 sample contain a larger amount of Na than the Experiment 2 sample. The photovoltaic conversion efficiency of the Experiment 3 sample is higher than the photovoltaic conversion efficiency of the Experiment 2 sample, so to obtain a high photovoltaic conversion efficiency, it is believed that a dispersed layer of ZnS-based fine particles which contains a larger amount of Na is desirable.

In the examples which are shown in Table 1, ZnS was used for the bottommost layer of the metal precursor film, but Table 2 shows the results of experiments for finding the optimum stacking order of the metal precursor film.

**Table 2**

| | Sample no. | Order of stacking precursor films | Photovoltaic conversion efficiency |
|---|---|---|---|
| Zn bottom layer | Sample 4 | Cu/Sn/ZnS/Mo | 6.94% |
| | Sample 5 | Sn/Cu/ZnS/Mo | 6.71% |
| Zn top layer | Sample 6 | Cu/ZnS/Sn/Mo | 3.97% |
| | Sample 7 | Sn/ZnS/Cu/Mo | 2.36% |
| | Sample 8 | ZnS/Cu/Sn/Mo | 3.93% |
| | Sample 9 | ZnS/Sn/Cu/Mo | 2.67% |

In Sample 4 and Sample 5, as shown in Table 2, the vapor deposited layer of ZnS is formed at the bottommost layer of the metal precursor film (interface with Mo metal back electrode layer 2), while in Sample 6 to Sample 9, it is formed at the middle layer or topmost layer of the metal precursor film. In each sample, the temperature of sulfurization of the metal precursor film was 560°C, while the sulfurization time was 15 minutes. Further, the rest of the film structure is based on the one which is shown in FIG. 1. All of the samples have the same structure.

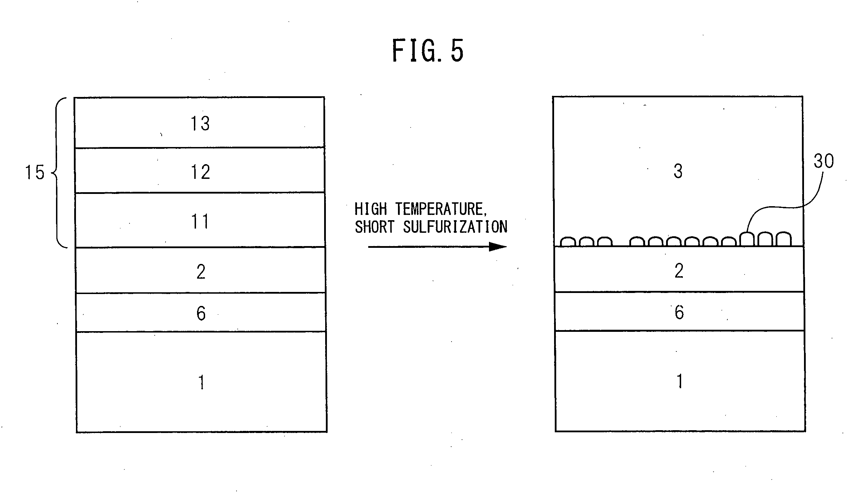

FIG. 5 shows an outline of the process of production of the samples which are shown in Table 2. In this experiment, Na-containing alkali glass is used as the substrate 1. To prevent the various types of metals and impurities which are contained in the glass substrate 1 from diffusing into the p-type CZTS-based light absorption layer 3, silica etc. is used to provide an alkali barrier layer 6. In Samples 4 and 5, as shown in FIG. 5, a ZnS layer is formed as the first layer (bottommost layer) of the precursor film 15 on the metal back electrode layer 2, an Sn layer (Sample 4) or Cu layer (Sample 5) is formed on the second layer 12, and a Cu layer (Sample 4) or Sn layer (Sample 5) is formed as the third layer 13 of the precursor film 15.

In Samples 6 to 9, as shown in Table 2, a layer other than ZnS (Cu layer or Sn layer) is formed at the first layer of the metal precursor film 15 (bottommost layer), and a ZnS layer is formed as the second layer 12 or the third layer 13.

If a metal precursor film 15 is formed in this way, high temperature, short sulfurization is performed in an atmosphere which contains hydrogen sulfide to sulfurize the metal precursor film 15 and form a p-type CZTS-based light absorption layer 3. At this time, a dispersed layer 30 of ZnS-based fine particles is formed at the interface between the metal back electrode layer 2 and p-type CZTS-based light absorption layer 3.

As clear from Table 2, in Sample 4 or 5 where ZnS is formed at the first layer of the precursor film 15, the photovoltaic conversion efficiency is in the high 6% range in each case. On the other hand, in Samples 6 to 9 where ZnS is formed as the top layer or middle layer of the metal precursor film 15, the photovoltaic conversion efficiency is in the 2% range or 3% range. This is much lower than Samples 4 and 5. The sulfurization temperature is a high temperature of 560°C and the sulfurization time is a short time of 15 minutes, so in Samples 4 and 5, a dispersed layer of ZnS fine particles is formed at the interface and, as a result, it is believed the photovoltaic conversion efficiency is improved.

On the other hand, in Sample 6 to Sample 9, the photovoltaic conversion efficiency is considerably low. Therefore, it is believed that a dispersed layer of ZnS fine particles is not sufficiently formed at the interface. This means that even if treating the metal precursor film by high temperature short sulfurization, if a vapor deposition layer of ZnS is not formed at the interface of the precursor film 15, a dispersed layer 30 of ZnS-based fine particles will be hard to form at the interface.

Note that, the layer which is formed as the first layer of the precursor film 15 does not necessarily have to be ZnS. For example, it may be Zn, ZnSe, ZnSSe, CuZn, CuZnS, CuZnSe, CuZnSSe, or other ingredient of Zn, a mixture of Zn and Cu, a mixture of Zn and a Group VI element, or a mixture of Zn, Cu, and a Group VI element (below, these called mixtures which contain Zn). Here, as the first layer of the precursor film 15, the example of Zn or a Zn mixture not containing a Group VI element was given, but the reason is that the energy of formation of a Zn (Group VI) compound is much lower compared with other compounds and formation is easy. This is because even if the first layer of the precursor film 15 does not contain a Group VI element, a dispersed layer 30 of ZnS-based fine particles can be formed in the later process of sulfurization and/or selenization. Further, when using a mixture which contains Zn to form the bottommost layer of the precursor film, the second layer or the third layer which is formed on that may also be Sn, SnS, SnSe, or SnSSe or Cu, CuS, CuSe, or CuSSe. Further, the second layer may be formed by any of CuSn, CuSnS, CuSnSe, and CuSnSSe. In this case, the third layer need not be formed. Furthermore, similar effects are obtained not only with high temperature short sulfurization, but also with high temperature short selenization and high temperature short sulfurization/selenization.

Table 3 shows the results of experiments which were run to clarify the effect which the high temperature short sulfurization of the precursor film and/or temperature and treatment time at the time of selenization have on the photovoltaic conversion efficiency.

**Table 3**

| | 5 min | 10 min | 15 min | 20 min | 25 min | 45 min |
|---|---|---|---|---|---|---|
| 600°C | | | 6.43% | | | |
| 580°C | 7.12% | 6.42% | | | | |
| 560°C | 5.40% | 6.43% | 6.94% | 6.53% | 6.63% | 4.33% |
| 540°C | | | 6.45% | | | |

The samples which are used in the experiments have a first layer of the metal precursor film 15 formed by a mixture which contains Zn, have glass substrates 1 using alkali-containing glass containing Na, and are provided with alkali barrier layers 6. The time in Table 3 shows the sulfurization time of the metal precursor film 15, while the temperature shows the sulfurization temperature. The structure of the film other than these are based on the one which is shown in FIG. 1. Each of the samples has the same structure.

As clear from Table 3, when making the sulfurization temperature 580°C, it was possible to obtain the highest photovoltaic conversion efficiency with a sulfurization time of 5 minutes of 7.12%. When the sulfurization temperature is lowered to 560°C, it was possible to obtain the highest photovoltaic conversion efficiency with a sulfurization time of 15 minutes of 6.94%. This means that if simply shortening the treatment time, it not possible to obtain a CZTS-based thin film solar cell which has a high photovoltaic conversion efficiency and that formation of a dispersed layer of ZnS-based fine particles requires a certain extent of heat. Further, overall, if the treatment time is within 25 minutes, a relatively high photovoltaic conversion efficiency can be obtained. If the treatment time exceeds 45 minutes, the dispersed layer of the ZnS-based fine particles is not effectively formed and the photovoltaic conversion efficiency is not improved.

Summarizing the above, by 1) forming the bottommost layer of the metal precursor film by a mixture which contains Zn and by 2) sulfurizing/selenizing the metal precursor film at a high temperature for a short time, a dispersed layer of ZnS-based fine particles is effectively formed at the interface and a CZTS-based thin film solar cell which has a high photovoltaic conversion efficiency can be obtained.

As explained above, if comparing FIGS. 3B and 3C, samples with a high concentration of Na near the interface with the Mo metal back electrode layer 2 have a high photovoltaic conversion efficiency. This is believed to be because by having the dispersed layer of ZnS-based fine particles which is formed near the interface contain a large amount of Na, the ZnS-based fine particles become higher concentration p-types and, as shown in FIG. 2B by the energy band diagram, a high energy barrier is formed at the metal back electrode side. To confirm this, the inventors prepared, as glass substrates 1, samples which use alkali-free glass not containing Na and solar cell samples which use alkali glass which contains Na: 3 to 13 wt% and measured them for photovoltaic conversion efficiency.

The results are shown in the following Table 4.

**Table 4**

| Sulfurization temperature | Sample no. | Glass substrate | Sulfurization time | | |
|---|---|---|---|---|---|
| | | | 5 min | 15 min | 45 min |
| 600°C | Sample 10 | Na (3 to 13%) | | 6.43% | |
| | Sample 11 | No Na (0%) | | 4.08% | |
| 560°C | Samples 12 to 14 | Na (3 to 13%) | 5.4% | 6.94% | 4.33% |
| | Samples 15 to 17 | No Na (0%) | | 2.99% | 1.76% |

The samples which were used for the experiments are provided with layers of mixtures which contain Zn (deposited layers) at the bottommost layers of the metal precursor films. Further, for the glass substrate 1, either alkali glass which contains Na: 3 to 13 wt% or alkali-free glass which does not contain Na is used. Between the glass substrate 1 and the Mo metal back electrode layer 2, an alkali barrier layer 6 which is formed by silica etc. is provided. This layer 6 is provided to keep the various types of metals or impurities which are contained in the glass substrate 1 from diffusing in the p-type CZTS-based light absorption layer 3 in the process of high temperature selenization of the precursor film 15.

The alkali barrier layer 6 is, for example, formed by RF sputtering using SiO₂ as the target. In this case, by adjusting the power which is input to the RF sputter system, the thickness can be controlled. The alkali barrier layer 6 of the samples which are shown in Table 4 is one which is formed using a power input to the RF sputter system of 0.6 kW.

Table 4 classifies eight solar cell samples which have the above structure by the temperature of the sulfurization treatment, whether the glass substrate 1 is alkali glass or alkali-free glass, and the high temperature sulfurization treatment time, and shows the photovoltaic conversion efficiency of the same. From Table 4, it will be understood that in Samples 10 and 12 to 14 which use alkali glass for the glass substrate 1, a relatively high photovoltaic conversion efficiency is obtained. In particular, it was possible to obtain a high photovoltaic conversion efficiency from Sample 13 which was treated for sulfurization at 560°C for 15 minutes. In Samples 11 and 15 to 17 which use alkali-free glass for the substrate 1, the photovoltaic conversion efficiency is considerably low. However, even in samples of alkali-free glass substrates, a relatively high photovoltaic conversion efficiency is exhibited with treatment at 560°C for 15 minutes. The effect of the dispersed layer 30 of ZnS fine particles which is formed by high temperature short sulfurization can be confirmed in the same way as Na-containing alkali glass substrate.

Table 5 shows the results of experiments for detecting the effect which the film thickness of the alkali barrier layer 6 has on the photovoltaic conversion efficiency when using alkali-containing glass as the substrate 1.

**Table 5**

| Sulfurization temperature | Alkali barrier deposition power | Sulfurization time 5 minutes | Sulfurization time 15 minutes |
|---|---|---|---|
| 580°C | 0.6 kW (Na diffusion amount large) | 7.31% | |
| | 1.3 kW (Na diffusion amount small) | 5.72% | |
| | 2.0 kW (Na diffusion amount very small) | 4.11% | |
| 560°C | 0.6 kW (Na diffusion amount large) | | 7.63% |
| | 1.3 kW (Na diffusion small) | | 6.82% |
| | 2.0 kW (Na diffusion amount very small) | | 6.03% |

In Table 5, the film thickness of the alkali barrier layer 6 is shown by the deposition power. The layer with a deposition power shown as 0.6 kW has the thinnest film thickness, while that shown as 2.0 kW has the thickest film thickness. "Na diffusion amount large" indicates that due to the film thickness of the alkali barrier layer being thin, a large amount of Na diffuses from the substrate 1 into the p-type CZTS-based light absorption layer 3. "Na diffusion amount small" and "Na diffusion amount very small" have similar meanings. The sulfurization treatment temperature, the film thickness of the alkali barrier layer, and the sulfurization treatment temperature were changed to form six solar cell samples. These were measured for photovoltaic conversion efficiency. Note that, in the case of these experiments as well, a Zn-containing layer was formed at the bottommost layer of the metal precursor film and a glass substrate 1 constituted by alkali-containing glass which contains Na: 3 to 13 wt% was used.

From Table 5, it will be understood that the thinner the film thickness of the alkali barrier layer, the higher the photovoltaic conversion efficiency. This is believed to be because by the alkali barrier layer being thin, the content of Na of the p-type CZTS-based light absorption layer 3, in particular near the interface with metal back electrode layer, becomes greater and the electron barrier effect which is shown in FIG. 2(B) becomes greater.

Summarizing the above, to effectively form a dispersed layer of ZnS-based fine particles to obtain a CZTS-based thin film solar cell with a high photovoltaic conversion efficiency, it is understood that it is important to 1) form a layer which contains Zn as a bottommost layer of the metal precursor film, 2) perform treatment in the sulfurization/selenization at a high temperature (540°C to 600°C) for a short time (5 minutes to 25 minutes), and 3) raise the Na concentration near the interface of the p-type CZTS-based light absorption layer and the metal back electrode layer.

Table 6 shows an example of the method of production, film thickness, etc. other than that explained above for the CZTS-based thin film solar cell of FIG. 1.

**Table 6**

| Substrate 1 | Alkali-containing glass or alkali-free glass | |
|---|---|---|
| Metal back electrode layer 3 | Composition | Mo |
| | Film thickness | 200 to 500 nm |
| | Deposition method | DC sputtering |
| | Deposition pressure | 0.5 to 2.5 Pa |
| | Deposition power | 1.0 to 3.0W/cm² |
| Metal precursor film 15 | Deposition method | Electron beam deposition method (EB deposition method) |
| p-type CZTS-based light absorption layer 3 | Film thickness | About 1 to 2 µm |
| n-type high resistance buffer layer 4 | Composition | CdS |
| | Film thickness | 3 to 50 nm |
| | Deposition method | Solution growth (CBD method) |
| n-type transparent conductive film 5 | Composition | BZO (boron doped ZnO) |
| | Film thickness | 0.5 to 2.5 µm |
| | Deposition method | MOCVD |

Note that, as the substrate 1, in addition to blue sheet glass, low alkali glass, or other glass substrate, a stainless steel sheet or other metal substrate, polyimide resin substrate, etc. may be used. As the method of formation of a metal back electrode layer 2, in addition to the DC sputtering which is described in Table 6, there are electron beam deposition, atomic layer deposition (ALD), etc. As the material of the metal back electrode layer 2, a high corrosion resistance and high melting point metal, for example, chromium (Cr), titanium (Ti), etc. may be used.

The n-type transparent conductive film 5 is formed using a material which has an n-type of conductivity, has a broad band gap, is transparent, and has a low resistance to a film thickness of 0.05 to 2.5 µm or so. Typically, there is a zinc oxide-based thin film (ZnO) or ITO thin film. In the case of a ZnO film, a Group III element (for example, Al, Ga, and B) is added as a dopant to obtain a low resistance film. An n-type transparent conductive film 5 can be formed by sputtering (DC, RF) etc. in addition to MOCVD.

### Reference Signs List

- 1: glass substrate
- 2: metal back electrode layer
- 3: p-type CZTS-based light absorption layer
- 4: n-type high resistance buffer layer
- 5: n-type transparent conductive film
- 6: alkali barrier layer
- 10: hole
- 12: first layer of metal precursor film
- 13: second layer of metal precursor film
- 14: third layer of metal precursor film
- 15: metal precursor film
- 20: electrons
- 30: dispersed layer of ZnS-based fine particles

## Claims

1. A CZTS-based thin film solar cell comprising:
a substrate,
a metal back electrode layer which is formed on said substrate,
a p-type CZTS-based light absorption layer which is formed on said metal back electrode layer, and
an n-type transparent conductive film which is formed on said p-type CZTS-based light absorption layer,
wherein a dispersed layer of ZnS-based fine particles is formed at the interface between said p-type CZTS-based light absorption layer and said metal back electrode layer.

2. The CZTS-based thin film solar cell according to claim 1, wherein said dispersed layer of ZnS-based fine particles does not completely cover the surface of said metal back electrode layer.

3. The CZTS-based thin film solar cell according to claim 1 or 2, wherein said ZnS-based fine particles have a size of 10 nm to 200 nmφ.

4. The CZTS-based thin film solar cell according to any one of claims 1 to 3, wherein said substrate is alkali glass which contains Na.

5. The CZTS-based thin film solar cell according to claim 4, further comprising an alkali barrier layer between said substrate and said metal back electrode layer.

6. The CZTS-based thin film solar cell according to any one of claims 1 to 5, wherein said ZnS-based fine particles contain any of ZnS, ZnSe, and ZnSSe.

7. The CZTS-based thin film solar cell according to any one of claims 1 to 6, further comprising an n-type high resistance buffer layer between said p-type CZTS-based light absorption layer and said n-type transparent conductive film.

8. A method of production of a CZTS-based thin film solar cell, comprising:
forming a metal back electrode layer on a substrate,
forming a metal precursor film which contains Cu, Sn, and Zn on said metal back electrode layer,
sulfurizing and/or selenizing said metal precursor film to form a p-type CZTS-based light absorption layer, and
forming an n-type transparent conductive film on said p-type CZTS-based light absorption layer,
wherein said metal precursor film has a bottommost layer at said metal back electrode layer side which is formed by a layer which contains Zn, and said sulfurization and/or selenization is performed at an ambient temperature of 540°C to 600°C for 5 minutes to 25 minutes.

9. The method of production of a CZTS-based thin film solar cell according to claim 8, wherein said substrate is formed by Na-containing alkali glass.

10. The method of production of a CZTS-based thin film solar cell according to claim 9, further comprising forming an alkali barrier layer between said substrate and said metal back electrode layer.

11. The method of production of a CZTS-based thin film solar cell according to any one of claims 8 to 10, wherein said metal precursor film is formed by depositing a ZnS layer on the metal back electrode layer as a mixture which contains Zn, then depositing Sn, Cu, or a mixture which contains these.

12. The method of production of a CZTS-based thin film solar cell according to any one of claims 8 to 11, further comprising forming an n-type high resistance buffer layer after forming said p-type CZTS-based light absorption layer and before forming said n-type transparent conductive film.
